Europäisches Patentamt

**European Patent Office**

**Office européen des brevets**

(11) Publication number: **0 227 894**
A2

# EUROPEAN PATENT APPLICATION

(21) Application number: 86112729.8

(22) Date of filing: 15.09.86

(51) Int. Cl.⁴: **H 01 L 29/78,** H 01 L 29/72, H 01 L 21/60, H 01 L 21/28, H 01 L 29/52

(30) Priority: 19.12.85 US 811925

(43) Date of publication of application: 08.07.87 Bulletin 87/28

(84) Designated Contracting States: BE DE FR GB IT NL

(71) Applicant: SILICONIX Incorporated, 2201 Laurelwood Road, Santa Clara California 95054 (US)

(72) Inventor: Cogan, Adrian I., 1174 Hyde Avenue, San Jose California 95129 (US)
Inventor: Blanchard, Richard A., 10724 Mora Dr., Los Altos California 94022 (US)

(74) Representative: Meddle, Alan Leonard et al, FORRESTER & BOEHMERT Widenmayerstrasse 4/I, D-8000 München 22 (DE)

(54) High density vertical DMOS transistor.

(57) A process for manufacturing a vertical DMOS transistor minimizes the number of steps requiring alignment. The processing includes the steps of forming a polycrystalline silicon gate structure (108) on a wafer of N type silicon (102), using the gate structure to define a P region (114) and an N+ region (116) within the P region, etching through a portion of the N region to expose the underlying P region, and then forming a metal layer (124) which contacts the P region and the remaining portion of the N region. Prior to the formation of the metal contacts, the method of the present invention requires no alignment steps.

ACTORUM AG

1

"High Density vertical DMOS Transistor and method of forming the same"

THIS INVENTION relates to improvements in or relating to double diffused MOS ("DMOS") transistors and more particularly to vertical DMOS transistors.

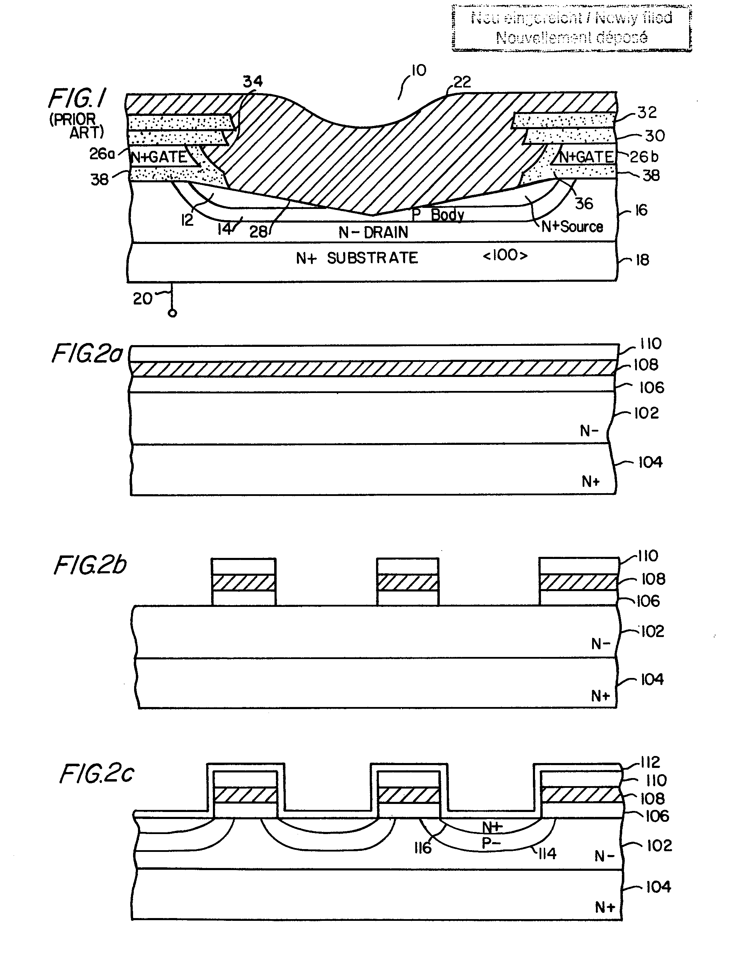

DMOS transistors are transistors in which the difference in the diffusion of sequentially introduced impurities from a common edge or boundary is used to define the channel lenth. Figure 1 of the accompanying drawings illustrates a prior art vertical DMOS transistor 10. DMOS transistor 10 includes an N+ source region 12 formed within a P type body region 14. Although drawn as two separate regions, N+ source region 12 is actually a single contiguous region joined outside the plane of the cross section of Figure 1. Body region 14 is formed in an N-epitaxial layer 16 which in turn is formed on an N+ substrate 18. N+ substrate 18 acts as a drain for transistor 10 and is connected to a bottom side electrical contact schematically illustrated as contact 20.

Transistor 10 includes a metal layer 22 which electrically contacts N+ source region 12 and P body region 14. A second metal conductor (not shown) contacts a pair of polycrystalline silicon gates 26a and 26b. (Although drawn as two gates, gates 26a and 26b are actually a single contiguous gate joined outside the plane of the cross section of Figure 1). In operation, when the voltage at gates 26a and 26b rises above a predetermined threshold voltage, an inversion region is formed in P body region 14 and current is permitted to flow between N+ source region 12 and epitaxial layer 16.

One process for manufacturing a DMOS transistor such as transistor 10 is discussed in U.S. Patent 4,516,143, issued to Robert P. Love on May 8, 1985. Love photolithographically defines gates 26a and 26b on epitaxial layer 16 and uses gates 26a and 26b to define body region 14 and source region 12. Love then etches a groove 28 in the wafer between gates 26a and 26b using an anisotropic etchant. Groove 28 extends through N+ source region 12 and part of P body region 14. Metal layer 22 is then deposited in groove 28 to form the source and body contact. Thus, Love manufactures his transistor while attempting to minimize the number of masking steps. Unfortunately, there are a number of problems with the Love process.

Firstly, because Love relies on an anisotropic etchant such as KOH to define groove 28 between gates 26a and 26b, the groove has walls sloped at about 54°. Because the groove must extend through N+ source region 12 and P type body region 14, and because the walls of groove 28 are sloped at 54°, the width of groove 28 is determined by the depth groove 28 must reach and therefore represents a limitation on how small devices can be manufactured.

Secondly, Love relies on the edge of an overhang comprising a silicon dioxide layer 30 and a silicon nitride layer 32 to define groove 28. As is known in the art, it is difficult to achieve metalization step coverage over such overhangs.

Thirdly, the process by which Love forms his overhang (i.e. under-etching polycrystalline silicon gates 26a and 26b) is difficult to control with precision.

Fourthly, Love forms a silicon dioxide layer 34 on the side of gates 26a and 26b. During the formation of silicon dioxide layer 34, a portion 36 of an insulation layer 38 underneath gates 26a and 26b increases in thickness. Because of this, the threshold voltage of transistor 10 in portion 30 increases. If it is desired to avoid this increase in threshold voltage, it is necessary to form N+ region 12 so that it extends past portion 30.

A process in accordance with the present invention for constructing a DMOS transistor includes the step of forming a gate structure on the surface of a first semi-conductor region of a first conductivity type. The gate structure is typically covered with a first insulating layer. In one embodiment of the invention, the first semi-conductor region is an epitaxial layer formed on a substrate of the first conductivity type. A second semi-conductor region of a second conductivity type is formed in the first semi-conductor region and a third semi-conductor region of the first conductivity type is formed within the second semi-conductor region. The second and third semi-conductor regions are typically formed by an ion implantation and serve as the source and body regions, respectively, of the DMOS transistor. The second and third semi-conductor regions are defined by the previously formed gate structure.

A layer of material such as low temperature oxide ("LTO") is then formed on the wafer. (As used herein, a low temperature oxide layer is a layer of silicon dioxide which is deposited on the wafer using a low temperature chemical vapour deposition process). The LTO layer is then etched using a blanket anisotropic etching process, leaving the first insulating layer on the gate structure and a sidewall spacer around the edges of the gate structure.

A portion of the third semi-conductor region is exposed during the anisotropic etching of the LTO layer. A groove having a lateral extent defined by the sidewall spacer is etched in and extends through the exposed portion of the third semi-conductor region and a portion of the second semi-conductor region lying thereunder. The third semi-conductor region is etched using a plasma or reactive ion etching (RIE) process. The walls of the groove etched in the third semi-conductor region are formed with a steeper slope than the walls of groove 28 in prior art transistor 10. Therefore, the width of the groove etched in the third semi-conductor region can be smaller than the width of groove 28.

Another advantage of using RIE or plasma etching is that by varying various parameters of the etching process, e.g. gas mixture, etc., it is possible to vary the slope of the wall of the groove, thereby providing an added degree of control over the process. Another advantage of the present process is that because the groove is defined by the sidewall spacer, the distance between the edge of the groove and the gate is smaller and more easily controlled then the corresponding distance in prior art transistor 10. A P+ or "deep body" region is then formed within the second semi-conductor region, e.g. by implanting impurities of the second conductivity type in the wafer. Of importance, all the processes up to and including the step of forming the deep body region are performed without requiring an alignment step. Because of this, the need to accommodate alignment tolerances up to this point is eliminated.

After the deep body region is formed, a gate contact window is etched in the first insulating layer and a layer of electrically conductive material is formed on the wafer and patterned, thereby forming source, body, and gate contacts. It is noted that the present process does not require any overhangs and thus it is easier to form good metalisation step coverage using the present process than the process discussed by Love.

In order that the invention may be readily understood, embodiments thereof will now be described, by way of example, with reference to the accompanying drawings, in which:

Figure 1 illustrates in cross section a vertical DMOS transistor constructed in accordance with the prior art;

Figures 2a to 2h illustrate in cross section a vertical DMOS transistor during a manufacturing process embodying with the present invention;

Figure 3 illustrates an insulated gate transistor constructed using a process embodying the present invention;

Figure 4 is a schematic diagram of the structure of Figure 3; and

Figure 5 is a schematic diagram of the structure of Figure 3 including a parasitic bipolar NPN transistor.

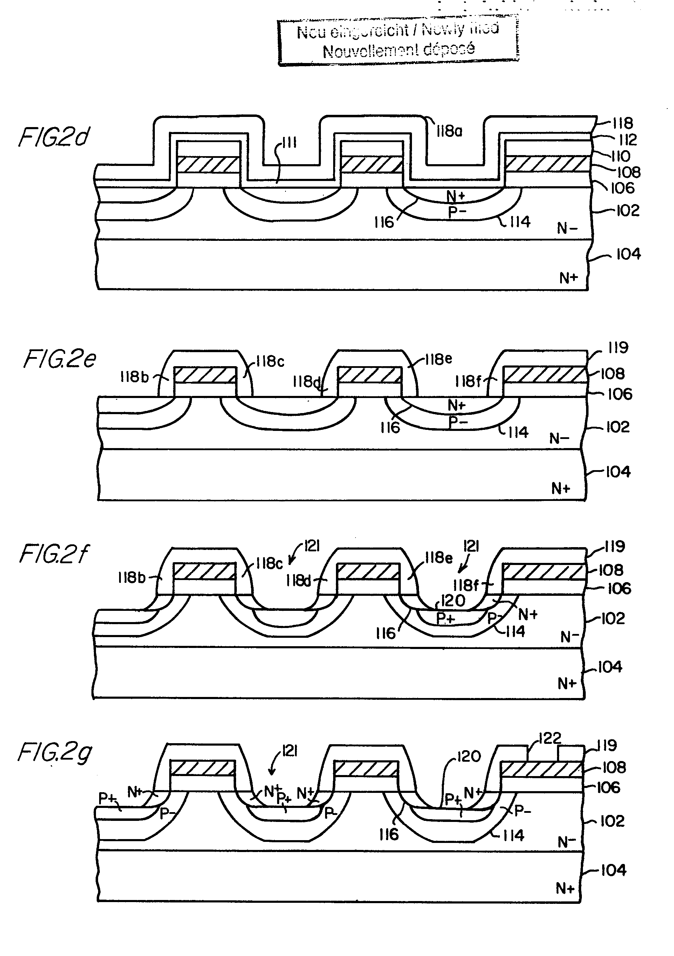

A process embodying the present invention is used to build a vertical DMOS transistor while minimizing the number of masking steps and the need to accommodate alignment tolerances. Figures 2a to 2h illustrate in cross section a portion of a DMOS transistor during a manufacturing process embodying the invention. It should be understood, however, that the DMOS transistor typically includes a plurality of cells or regions having a cross section as illustrated in Figures 2a to 2h.

In accordance with this process an N- epitaxial layer 102 is formed on an N+ substrate 104. In one embodiment, N+ substrate 104 is silicon having a conductivity of about .01Ω-cm and a [100] crystal orientation but semiconductor materials, including materials other than silicon, having other conductivities, conductivity types, and crystal orientations are also appropriate. Epitaxial layer 102 is also typically silicon, has a conductivity of 0.5 to 100Ω-cm and is typically 5 to 100μm thick.

A first silicon dioxide layer 106, a polycrystalline silicon layer 108 and a second silicon dioxide layer 110 are formed on epitaxial layer 102. In one embodiment, silicon dioxide layer 106 is thermally grown to a thickness of 100nm and serves as gate insulation in the DMOS transistor. Polycrystalline silicon layer 108 serves as the gate for the DMOS transistor and is typically formed by chemical vapour deposition to a thickness of 500nm. It will be appreciated, however, that materials other than polycrystalline silicon, such as a refractory metal, can be used as the transistor gate.

Silicon dioxide layer 110 is typically thermally grown to a thickness of 400nm, and insulates polycrystalline silicon layer 108 from a subsequently deposited metal layer. In other embodiments, silicon dioxide layer 10 is an LTO layer.

Referring to Figure 2b, silicon dioxide layers 106 and 110 polycrystalline silicon layer 108 are then patterned. This is typically done by covering silicon dioxide layer 110 with photoresist (not shown), developing the photoresist, thereby exposing portions of the underlying silicon dioxide layer 110, and removing the exposed portions of silicon dioxide layer 110 and the portions of polycrystalline silicon layer 108 and silicon dioxide layer 106 lying thereunder.

Referring to Figure 2c, a thin silicon dioxide layer 112 is then formed over the entire wafer surface area. In one embodiment, silicon dioxide layer 112 is thermally grown to a thickness of 50nm. Silicon dioxide layer 112 prevents outgassing of dopants from polycrystalline silicon gate 108 into epitaxial layer 102 during the subsequent formation of a P type body region 114 and N+ region 116. P type body region 114 is then formed, e.g. by ion implantation. In one embodiment, dopants such as baron or aluminium are implanted into the wafer with a dosage of about $10^{12}$ to $10^{14}/cm^2$ and an implant energy of approximately 60 to 120 Kev. The wafer is then subjected to a diffusion process.

An N+ region 116, which serves as the transistor source region, is then formed. In one embodiment, this is done by ion implantation, for example, using phosphorus or arsenic ions, a dosage of about $10^{15}$ to $10^{16}$ per $cm^2$ and an implant energy of approximately 100 Kev. The wafer is then subjected to a short annealing and diffusion process.

Referring to Figure 2d, an LTO layer 118 is then formed on the wafer, e.g. by chemical vapour deposition. In one embodiment, LTO layer 118 is deposited at a temperature of about $750^{o}C$ and has a thickness of about 0.7µm to 1.5µm. Because LTO layer 118 is deposited at a relatively low temperature, dopants in regions 114 and 116 do not diffuse during this process. LTO layer 118 can be caused to flow, eg. by heating the wafer to a temperature of $950^{o}C$ for 0.3 hours. This results in the formation of a smooth corner region 118a.

LTO layer 118 is then etched by a non-selective blanket anisotropic etching process in order to form sidewall spacers 118b, 118c, 118d, 118e and 118f of Figure 2e. In one embodiment, LTO layer 118 is etched with a reactive ion etching process (RIE), but plasma etching or ion milling are also appropriate. At the conclusion of this step, sidewall spacers 118b through 118f (Figure 2e) remain along the sides of polycrystalline silicon gate 108. The RIE process is timed to avoid etching through silicon dioxide layer 110. Of importance, the silicon dioxide on top of polycrystalline silicon gate 108 (including layers 110, 112 and 118) is thicker than the silicon dioxide layer formed directly on portion 111 of epitaxial layer 102 (including only layers 112 and 118). Therefore, by appropriately timing the RIE process, silicon dioxide layers 112 and 118 are etched without removing silicon dioxide layer 110 on polycrystalline silicon gate 108. As illustrated in Figure 2e, the remaining portions of the silicon dioxide layers 112, 118 and 110 have been redrawn as a single silicon dioxide layer 119.

Referring to Figure 2f, the portion of N+ region 116 exposed during the etching of LTO layer 118 is thn removed, thereby forming a groove 119 in the wafer and exposing a portion of P- body region 114. This is typically accomplished using either a plasma, RIE or wet etching process. A negligible portion (typically 200nm) of P region 114 is also typically removed during this process. Of importance, sidewall spacers 118b to 118f protect a portion of N+ source region 116 during this etching process. Because sidewall spacers 118b to 118f are relatively narrow (about 0.5μm), the edge of groove 119 is close to the edge of gate 108. This is important because it is desirable to minimize the size of the DMOS transistor.

A P+ deep body region 120 is then formed. In one embodiment, this is done by subjecting the wafer to an ion implantation process using boron ions, a dosage of about $10^{15}$ ions/cm$^2$, and an implant energy of approximately 100 Kev. The implanted ions are then diffused.

It is noted that up to this stage in the process, no alignment steps are necessary during fabrication of the transistor. It is therefore unnecessary to allow for alignment tolerances during this process.

Referring to Figure 2g, a window 122 is formed in silicon disoxide layer 119. This is typically accomplished by forming a layer of photoresist (not shown) on the wafer and photolithographically forming a window region in the photoresist, thereby exposing a portion of silicon dioxide layer 119. The exposed portion is then removed, leaving window region 122, which defines an electrical contact to polycrystalline silicon gate 108.

Referring to Figure 2h, a layer of conductive material such as metal layer 124 is formed on the wafer. Metal layer 124 is typically aluminium or an alloy of aluminium. In other embodiments, other conductive materials such as polycrystalline silicon are used. Metal layer 124 is then patterned, e.g. by covering the wafer with a photoresist layer (not shown), developing the photoresist, thereby exposing portions of metal layer 124, and removing the exposed portions of metal layer 124. The resulting structure includes a portion 124b of metal layer 124 which contacts source region 116 and deep body region 120 of the DMOS transistor and a portion 124a which contacts polycrystalline silicon gate 108.

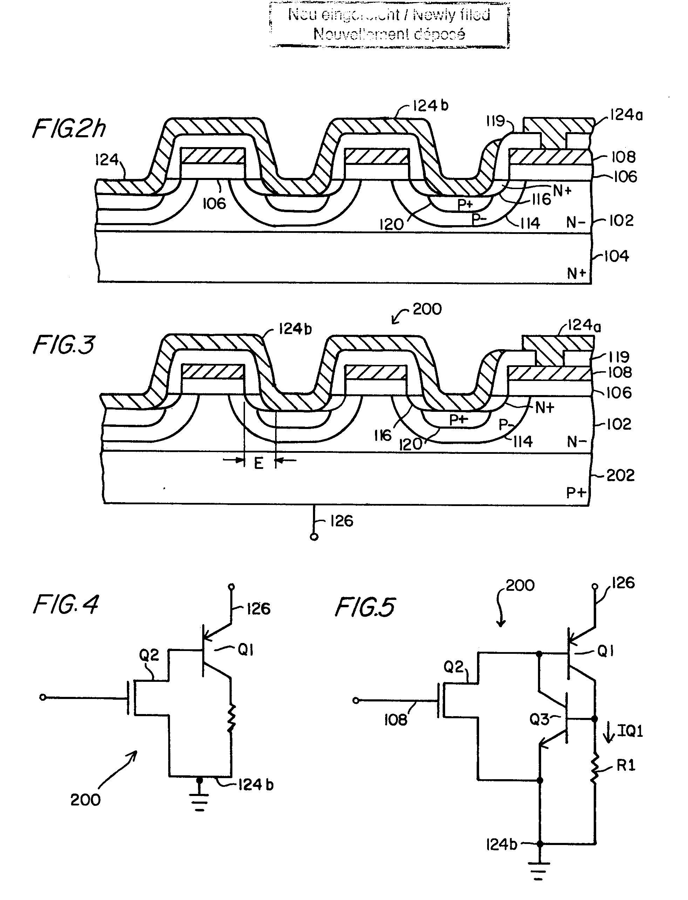

Referring to Figure 3, in an alternative embodiment, instead of forming N- epitaxial layer 102 on an N+ substrate 104, epitaxial layer 102 is formed on a P+ substrate 202. The remaining process steps used to form the structure of Figure 3 are the same as those described above. The structure of Figure 3 acts as an insulated gate transistor ("IGT") 200. Insulated gate transistors are discussed in greater detail in "The Insulated Gate Transistor: A New Three-Terminal MOS-Controlled Bipolar Power Device", by Blaiga et al., published in IEEE Transactions On Electron Devices, Vol. ED-31, No. 6, in June, 1984. Figure 4 schematically illustrates IGT 200. Referring to Figures 3 and 4, it is seen that P+ substrate 202 and N- epitaxial layer 102 serve as the emitter and base, respectively, of a PNP bipolar transistor Q1. Similarly, P- body region 114 and P+ deep body region 120 serve as the collector of bipolar transistor Q1. In addition, N- epitaxial layer 102, P regions 114 and 120 and N+ source region 116 serve as the drain, body region and source of DMOS transistor Q2, respectively. The structure of Figure 4 is used to selectively couple backside contact 126 metal contact 124b. Specifically, when the voltage at gate 108 rises above the threshold voltage of DMOS transistor Q2, transistor Q2 turns on, permitting base current from bipolar transistor Q1 to flow, thereby turning on transistor Q1 and coupling metal 124b to contact 126.

It will be appreciated by those skilled in the art that when using the above-described process to manufacture IGT 200 of Figure 3, the resulting structure can be formed using a smaller surface area than previously possible. In addition, the structure of Figure 3 provides an added advantage in that it is more difficult to cause parasitic SCR latch-up in IGT 200. The reason for this is as follows. In the structure of Figure 3, N+ source region 116, body region 114 and N- epitaxial layer 102 act as the emitter, base and collector, respectively, of a parasitic bipolar NPN transistor Q3 schematically illustrated in Figure 5. Also illustrated in Figure 5 is resistor R1 which models the parasitic resistance of the portion of P- body region 114 between epitaxial layer 102 and metal 124b. When transistor Q1 turns on, a current $I_{Q1}$ flows through resistor R1. If current $I_{Q1}$ is large enough, the base-emitter junction of NPN transistor Q3 becomes forward biased, and transistor Q3 turns on. Latch-up occurs when collector current from transistor Q1 keeps transistor Q3 on and collector current from transistor Q3 keeps transistor Q1 on, even after transistor Q2 turns off.

It will be appreciated that resistance R1 is small because length E (the length of the portion of P- region 114 extending from metal 124b to the edge of N+ region 116) is small. In other words, a large current would be required to flow along distance E to cause a large enough voltage drop to forward bias the junction between regions 114 and 116. Therefore, IGT 200 is less susceptible to SCR latch-up than prior art IGT structures.

The features disclosed in the foregoing description, in the following claims and/or in the accompanying drawings may, both separately and in any combination thereof, be material for realising the invention in diverse forms thereof.

CLAIMS:

1. A method of forming a transistor comprising the steps of: forming on a surface of a first semi-conductor region having a first conductivity type gate having an edge; forming a second semi-conductor region having a second conductivity type opposite to the first conductivity type within the first semi-conductor region, an edge of the second semi-conductor region being defined by the edge of the gate; forming a third semi-conductor region having the first conductivity type within the second semi-conductor region, the third semi-conductor region having an edge defined by the edge of the gate, the second semi-conductor region laterally extending a greater distance under the gate than the third semi-conductor region; etching a groove through a portion of the third semi-conductor region, thereby exposing a portion of the second semi-conductor region, whereby the first semi-conductor region, the second semi-conductor region, and the third semi-conductor region serves as a drain, body region and source, respectively, of the transistor.

2. A method according to claim 1 comprising the step of forming a sidewall spacer extending from the edge of the gate and defining the edge of the groove.

3. A method according to claim 2, wherein said sidewall spacer, is formed by depositing a layer of LTO on the surface and anisotropically etching the LTO layer.

4. A method according to claim 1, 2 or 3, wherein all of the steps of claim 1, 2 or 3 are performed without performing an alignment step.

5. A method according to any preceding claim comprising the step of forming electrical contacts to the transistor, wherein all of the fabrication steps used to form the transistor prior to the step of forming electrical contacts are performed without an alignment step.

6. A method according to any preceding claim wherein the first semi-conductor region is an epitaxial layer formed on a substrate of the first conductivity type.

7.    A method according to claim 6, wherein the substrate, epitaxial layer and second semi-conductor region serve as the emitter, base and collector, respectively of a bipolar transistor.

8.    A method according to any preceding claim comprising the step of forming a deep body region of the second conductivity type within the second semi-conductor region, the deep body region being defined without performing an alignment step.

9.    A method according to any preceding claim comprising the step of forming a layer of conductive material in the groove, the conductive material serving as a source and body contact lead, the groove defining the area where said conductive material electrically contacts the source and body.

10.    A method of forming a transistor according to any preceding claim comprising forming an insulating layer over the gate, the insulating layer extending over the top and the said edge of the gate, whereby the portion of said insulating layer covering the corner of the gate where the said gate edge meets said top has a smooth profile.

11.    A transistor comprising: a first semi-conductor region having a first conductivity type; a second semi-conductor region having a second conductivity type formed within the first semi-conductor region; a third semi-conductor region having the first conductivity type formed within the second semi-conductor region; a gate formed above the portion of the second semi-conductor region between the first and third semi-conductor regions, the gate having an edge; a sidewall spacer formed adjacent to said edge, a groove being formed in the second semi-conductor region, the groove extending through the second semi-conductor region and part of the third semi-conductor region, the groove having an edge extending to the sidewall spacer; and a layer of conductive material electrically contacting the second and third semi-conductor regions in the groove.

12.    A transistor according to claim 11, wherein the sidewall spacer and gate have a smooth cross section profile, thereby facilitating metalization step coverage.

13. A transistor according to claim 11 or 12, wherein the first semi-conductor region comprises an epitaxial layer, the epitaxial layer being formed on a substrate of the first conductivity type.

14. A transistor according to claim 11 or 12, wherein the first semi-conductor region comprises an epitaxial layer, the epitaxial layer being formed on a substrate of the second conductivity type.

0227894

**FIG.1**
(PRIOR ART)

34  10  22

32
30
26a  N+GATE  N+GATE  26b
38  38
36  16
12  14  28  P Body
N−DRAIN  N+Source
N+ SUBSTRATE  <100>  18

20

**FIG.2a**

110
108
106
102
N−
N+  104

**FIG.2b**

110
108
106
102
N−
104
N+

**FIG.2c**

112
110
108
106
N+
P−
116  114  N−  102
104
N+

FIG.2d

FIG.2e

FIG.2f

FIG.2g

*FIG2h*

*FIG.3*

*FIG.4*

*FIG.5*